# EUROPÄISCHE PATENTSCHRIFT

(11) **EP 0 642 703 B1**
(45) Veröffentlichungstag und Bekanntmachung des Hinweises auf die Patenterteilung: **17.04.1996**
(21) Anmeldenummer: 93909799.4
(22) Anmeldetag: 24.05.1993
(51) Int. Cl.: H02K 9/197, H02K 11/00, H02K 29/00

(54) **ELEKTRISCHE MASCHINE MIT HALBLEITERVENTILEN**
ELECTRIC MACHINE WITH SEMICONDUCTOR VALVES
MACHINE ELECTRIQUE MUNIE DE VALVES A SEMI-CONDUCTEURS

(30) Priorität: 25.05.1992 DE 4217289
(43) Veröffentlichungstag der Anmeldung: 15.03.1995
(73) Patentinhaber: FICHTEL & SACHS AG, D-97424 Schweinfurt (DE)
(72) Erfinder: LUTZ, Dieter, D-8720 Schweinfurt (DE)
(74) Vertreter: Meissner, Peter E., Dipl.-Ing.
(86) Internationale Anmeldenummer: DE9300466
(87) Internationale Veröffentlichungsnummer: WO9324983

(56) Entgegenhaltungen:
- EP-A- 0 231 785
- DE-A- 3 917 040
- FR-A- 2 430 126
- FR-A- 2 512 601
- US-A- 3 250 929
- US-A- 3 564 306
- US-A- 3 896 320

## Beschreibung

Die Erfindung betrifft eine elektrische Maschine gemäß dem Oberbegriff des Patentanspruchs 1.

Beim Betrieb einer elektrischen Maschine entsteht in den Wicklungen Verlustwärme, die nach außen abgeführt werden muß. Im Regelfall wird hierzu eine Belüftungskühlung herangezogen. Aus der DE-A-39 32 481 ist es bekannt, einen Kühlfluidkanal als Baueinheit mit den Wicklungen der elektrischen Maschine zu verbinden, um die Effektivität der Kühlung zu steigern und dadurch eine höhere Leistungsdichte der Maschine zu ermöglichen.

Zur Steuerung einer solchen elektrischen Maschine ist eine Leistungselektronik erforderlich, deren elektronische Schaltelemente wegen der vergleichsweise hohen zu schaltenden Leistungen auch als elektrische Ventile oder Halbleiterventile bezeichnet werden. In den Halbleiterventilen fällt ebenfalls Verlustwärme an, die abgeführt werden muß, damit eine Überhitzung, die zu einer Zerstörung der Halbleiterventile führen würde, vermieden wird. Hierzu ist es bekannt, die Halbleiterbauelemente in Wärmeübertragungskontakt mit speziellen Kühlkörpern zu bringen, die Verlustwärme aufnehmen und abführen. Dabei kann die Wärmeabfuhr aus den Kühlkörpern durch eine Luft- oder Flüssigkeitskühlung erfolgen.

Bei herkömmlichen, von elektrischen Ventilen gesteuerten elektrischen Geräten oder Maschinen sind die elektrischen Ventile gesondert von dem zu steuernden elektrischen Gerät angeordnet, und für die Kühlung der Ventile einerseits und des Geräts andererseits sind in der Regel gesonderte Kühlkreisläufe vorgesehen. Dies trifft insbesondere für elektrische Maschinen, d.h. elektrische Generatoren und/oder Motoren (je nach Betriebsart) zu, die über elektrische Ventile geschaltet und/oder kommutiert werden sollen. Kompakte elektrische Maschinen hoher Leistungsdichte sind erforderlich, wenn sie zum Antrieb von Fahrzeugen, beispielsweise Kraftfahrzeugen, eingesetzt werden, wie dies zum Beispiel in P. Ehrhart "Das elektrische Getriebe von Magnet-Motor für PKW und Omnibusse" VDI Berichte Nr. 178, 1991, Seiten 611 bis 622, beschrieben ist. Für solche Anwendungsfälle geeignete Motoren sind beispielsweise aus der EP-A-159 005 und der DE-A-39 32 481 bekannt; Steuerschaltungen für solche Motoren sind in der EP-A-340 686 beschrieben. Derartige Motoren haben beispielsweise eine Leistung bis zu mehreren 100 kW bei einer Betriebsspannung von etwa 1000 V und entsprechenden Strömen.

Die EP-A- 0 231 785 offenbart einen Kraftfahrzeug-Generator, dessen Wicklungen mit Gleichrichter-Dioden und mit einer Elektronik für die Spannungsregelung verbunden sind, wobei diese Bauelemente wie die Wicklungen in Wärmeaustauschkontakt mit einem in einem Kanal fließenden Kühlfluid stehen.

Aufgabe der Erfindung ist es, den Platzbedarf einer gattungsgemäßen elektrischen Maschine, bei der es sich um einen Generator und/oder einen Motor, insbesondere für die Verwendung in einem Fahrzeugantrieb handeln kann, weiter zu verringern und zugleich das Betriebsverhalten der Maschine zu verbessern.

Diese Aufgabe wird erfindungsgemäß durch die kennzeichnenden Merkmale des Anspruchs 1 gelöst.

Ausgehend von einer elektrischen Maschine, deren Feldwicklungen an von

einer Steuerschaltung steuerbare Halbleiter-Ventile, insbesondere in Form von Leistungstransistoren wie z.B. BIMOS, IGBT und MOSFET, angeschlossen sind und in Wärmetauschkontakt mit einer Fluid-Kühlanordnung stehen, in deren zu einer Baueinheit mit den Feldwicklungen vereinigten Kühlfluidkanal die Kühlanordnung eine Zwangsströmung eines Kühlfluids, insbesondere einer Kühlflüssigkeit, erzeugt, wird dieses Ziel dadurch erreicht, daß die Halbleiterventile ebenfalls Bestandteil der Baueinheit sind und mit dem Kühlfluid in dem Kühlfluidkanal gleichfalls in Wärmetauschkontakt stehen. Die Halbleiterventile sind damit in die elektrische Maschine integriert und werden gemeinsam gekühlt. Die Halbleiterventile, die bevorzugt auf der Innenseite des Fluidkanals angeordnet sind und in direktem Kontakt mit dem Kühlfluid stehen, können kompakter aufgebaut werden als bisher üblich. Die räumliche Nähe der zu schaltenden Feldwicklungen zu den Halbleiterventilen mindert darüber hinaus Zuleitungsinduktivitäten beträchtlich, was die Schaltgeschwindigkeit der Halbleiterventile erhöht und dadurch das Betriebsverhalten der elektrischen Maschine verbessert. Hinzu kommt, daß Schraub- und Steckeranschlüsse durch kostengünstigere und funktionssicherere direkte Verschweißung oder Verlötung der Spulendrähte ersetzt werden können. Der direkte Kontakt mit der Chipfläche ist über eine Mehrfachbondung oder über Kupferbleche oder -Litze möglich. Zur Zugentlastung sollte dieser Bereich mit einer Vergußmasse geschützt werden.

In einer bevorzugten Ausgestaltung bilden die Feldwicklungen der elektrischen Maschine eine Statorwicklung und sind in Umfangsrichtung des Stators verteilt angeordnet, wie dies beispielsweise in der EP-A-159 005 beschrieben ist. Um die Zuleitungen möglichst kurz zu halten, sind die Halbleiterventile an dem Stator in räumlicher Nachbarschaft der mit ihnen verbundenen Feldwicklung bzw. Feldwicklungen angeordnet.

Der Stator der zweckmäßigerweise einen Permanentmagnetrotor, insbesondere einen Permanentmagnet-Außenrotor umfassenden Maschine hat bevorzugt ein die Feldwicklungen tragendes Blechpaket und eine zentrische Aussparung, in der zumindest ein Teil der Halbleiterventile angeordnet ist. Dementsprechend verlaufen auch Teile des Kühlfluidkanals durch diese Aussparung. Zumindest ein Teil der Halbleiterventile kann jedoch auch im Bereich einer axialen Stirnwand des Stators in Wärmetauschkontakt mit in diesem Bereich verlaufenden Teilen des Kühlfluidkanals stehen. In beiden Fällen kann ohnehin vorhandener Bauraum oder aber ohnehin bereits für Teile des Kühlfluidkanals genutzter Bauraum zur Unterbringung der Halbleiterventile ausgenutzt werden. Die Anordnung sollte jedoch so getroffen sein, daß die Feldwicklungen in Strömungsrichtung des Kühlfluids hinter den Halbleiterventilen in Wärmetauschkontakt mit dem Kühlfluid stehen, um die Kühlung der Halbleiterventile vorrangig sicherzustellen. Zur Verbesserung des Wärmeübergangs sollte im gesamten Bereich des Wärmeaustauschs eine hohe Strömungsgeschwindigkeit erzwungen werden. Um den Energieaufwand beim Betrieb (Druckverluste) möglichst niedrig zu halten, wird in Weiterbildung der Erfindung vorgeschlagen, den Kühlfluidkreislauf zonenweise (Leistungselektronik, Motorwicklungen) durch untergeordnete Umwälzkreisläufe für das Kühlfluid zu ergänzen.

Die Halbleiterventile können zumindest teilweise auch so angeordnet werden, daß ihre aktiven Bereiche von der Innenseite des Fluidkanals abgewandt sind. Sie können beispielsweise außen auf die Wandung des Fluidkanals aufgesetzt sein. Besonders bevorzugt ist es, wenn die Halbleiterventile einen integralen Bestandteil der Fluidkanalwandung bilden.

Um den Wärmetausch zum Kühlfluid hin zu steigern, kann in vorteilhafter Weiterbildung der Erfindung vorgesehen sein, daß zumindest ein Teil der dem Kühlfluid ausgesetzten Oberflächen des Fluidkanals und/oder der Halbleiterventile mit einer die Dicke der Kühlfluid-Strömungsgrenzschicht herabsetzenden Oberflächen-Mikrostruktur versehen ist. Derartige Mikrostrukturen sind aus der Natur bekannt (z.B. Haut von Haifischen).

Als Kühlfluid kommen zwar auch Gase, insbesondere Gase (z.B. N₂) mit erhöhtem Druck in Frage. Bevorzugt wird aber eine Kühlflüssigkeit wie etwa Wasser oder Öl, speziell Öl auf Mineralbasis oder Paraffinbasis oder synthetisches Öl. In manchen Fällen können auch Zwei-Phasen-Fluide, insbesondere ein Kältemittel oder CO₂, besonders zweckmäßig sein. Im folgenden werden Ausführungsbeispiele der Erfindung, die weitere vorteilhafte Ausgestaltungen enthalten, anhand einer Zeichnung näher erläutert. Hierbei zeigt:
- Fig. 1: einen schematischen Teilschnitt durch eine von fluidgekühlten elektrischen Ventilen gesteuerte elektrische Maschine,
- Fig. 2 bis 6: Teilschnitte durch Varianten der elektrischen Maschine aus Fig. 1 und
- Fig. 7 und 8: schematische Darstellungen von Kühlkreisläufen.

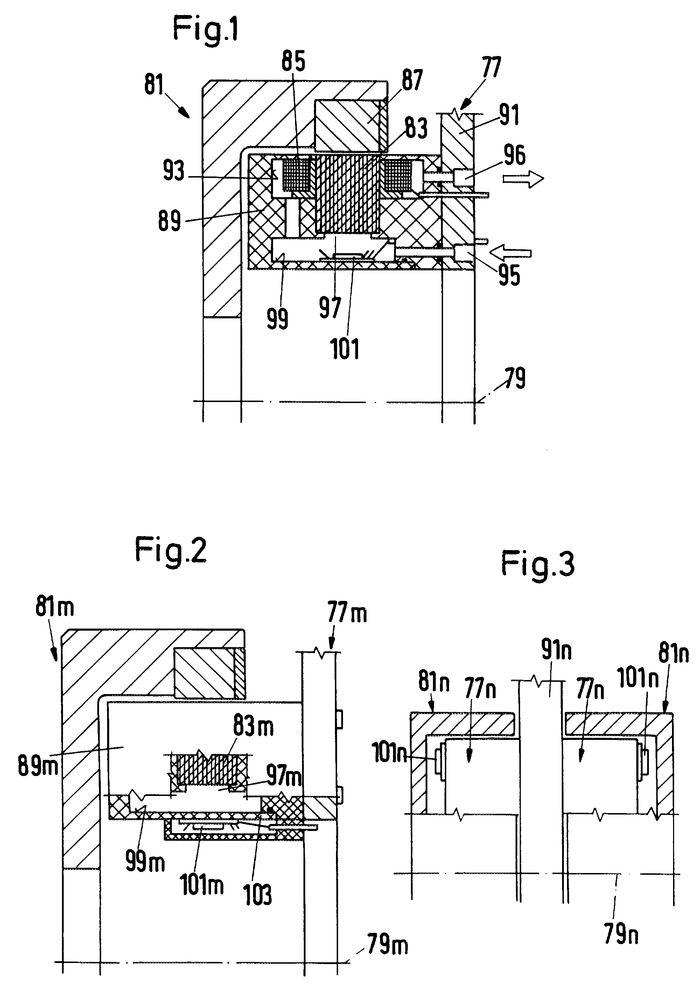

Figur 1 zeigt eine elektrische Maschine mit einem Stator 77 und einem um eine Drehachse 79 drehbaren Rotor 81. Die Maschine kann je nach Bedarf als Motor oder als Generator betrieben werden. Der Stator 77 umfaßt ein Weicheisen-Blechpaket 83, das im wesentlichen ringförmig ausgebildet ist und auf einer Vielzahl in Umfangsrichtung verteilter, nicht näher dargestellter Pole Wicklungen 85 trägt. Der Rotor 81 umschließt das Blechpaket 83 mit einer Vielzahl in Umfangsrichtung abwechselnd gegeneinander gepolter Permanentmagnete 87. Das Blechpaket 83 und die Wicklungen 85 sind in einem Statorgehäuse 89 (z.B. aus Kunststoff) untergebracht, welches seinerseits an einer stationären, beispielsweise plattenförmigen Aufhängung 91 gehalten ist. Elektrische Maschinen dises Typs sind bekannt, beispielsweise aus der EP-A-159 005, und sollen deshalb nicht weiter beschrieben werden.

Da elektrische Maschinen des genannten Typs für sehr hohe Leistungen von beispielsweise 100 kW bei vergleichsweise geringem Platzbedarf bemessen sein können, sind die Wicklungen 85 in einer oder mehreren Kammern 93 angeordnet, die über einen Zuleitungsanschluß 95 und einen Ableitungsanschluß 96 mit dem Kühlfluidkreislauf einer Kühlanordnung verbunden sind.

Das Blechpaket 83 umschließt eine zentrische Aussparung 97, in der das Statorgehäuse 89 eine weitere Kammer 99 bildet. Die Kammer 99 liegt im Kühlfluidströmungskreislauf der Kühlanordnung zwischen dem Zuleitungsanschluß 95 und der Kammer 93 der Wicklung 85, so daß sie von dem Kühlfluid durchströmt wird, bevor dieses sich an der Wicklung 85 erwärmt. In der Kammer 99 sind die der Wicklung 85 zugeordneten elektrischen Ventile 101 in unmittelbarer Nähe zu der zu schaltenden Wicklung 85 untergebracht. Bei den elektrischen Ventilen kann es sich um herkömmliche Leistungstransistoren handeln, vorzugsweise handelt es sich jedoch um fluidgekühlte Leistungstransistoren, bei denen eine geschlossenflächig stoffschlüssig mit dem Halbleiterelement verbundene Metallelektrode ihrerseits stoffschlüssig mit einem Isolierträger verbunden ist und wobei mindestens eine Flachseite des Isolierträgers und/oder des Halbleiterelements weitgehend vollflächig direkt dem Kühlfluid ausgesetzt ist; dabei ist auch die Steuer- und Schutzbeschaltung für das Halbleiterelement auf dem Isolierträger angeordnet und in Wärmeaustauschkontakt mit dem Kühlfluid. Die Verbindungsleitungen zwischen dem elektrischen Ventil 101 und der Wicklung 85 verlaufen direkt durch das Statorgehäuse 89 und sind vorzugsweise ohne lösbare Anschlußklemmen oder dergleichen direkt mit den Ventilen 101 verbunden, beispielsweise angeschweißt oder angelötet.

Auch kann daran gedacht werden, die Drahtenden der Wicklungen 85 direkt mit den Halbleiterelementen der Ventile zu verschweißen.

Figur 2 zeigt eine Variante der elektrischen Maschine mit einem Stator 77m und einem um eine Drehachse 79m drehenden Rotor 81m, die sich von der elektrischen Maschine der Figur 1 im wesentlichen nur dadurch unterscheidet, daß die elektrischen Ventile 101m nicht innerhalb der vom Kühlfluid durchströmten Kammer 99m des Statorgehäuses 89m angeordnet sind, sondern durch eine Trennwand 103 davon getrennt sind. Die Trennwand 103 kann dabei die tragende Basis des Halbleiterventils 101m darstellen, so daß gewährleistet ist, daß die elektrischen Ventile 101m auf ihrer den aktiven Teilen abgewandten Flachseite ebenfalls mit dem Kühlfluid in direkten Wärmeaustauschkontakt treten, vorzugsweise bevor der Wärmeaustauschkontakt mit der Wicklung stattfindet.

Figur 3 zeigt einen insbesondere als Fahrzeugantrieb verwendbaren Doppelmotor, der axial beiderseits einer Aufhängungsplatte 91n je einen Stator 77n trägt, dem je ein um eine gemeinsame Drehachse 79n rotierender Permanentmagnetrotor 81n zugeordnet ist. Die den nicht näher dargestellten, jedoch entsprechend der Fig. 1 angeordneten Wicklungen zugeordneten elektrischen Ventile 101n sind im Bereich der axialen Stirnflächen der Statoren 77n angeordnet, und zwar wiederum in unmittelbarer Nähe der durch sie zu schaltenden Wicklungen. Die Ventile 101n stehen im Ausführungsbeispiel der Figur 3 über eine Trennwand getrennt mit dem Kühlfluidkreislauf der Kühlanordnung der Wicklungen in Wärmeaustauschkontakt. Bei der Trennwand kann es sich um Isolierträger von Halbleiterelementen handeln; die elektrischen Ventile bzw. Halbleiterelemente können aber auch analog zu Fig. 1 innerhalb einer im Kühlfluidströmungsweg liegenden Kammer angeordnet sein. Es versteht sich, daß die elektrische Maschine gleichzeitig sowohl entsprechend den Figuren 1 und 2 als auch entsprechend Figur 3 angeordnete elektrische Ventile umfassen kann.

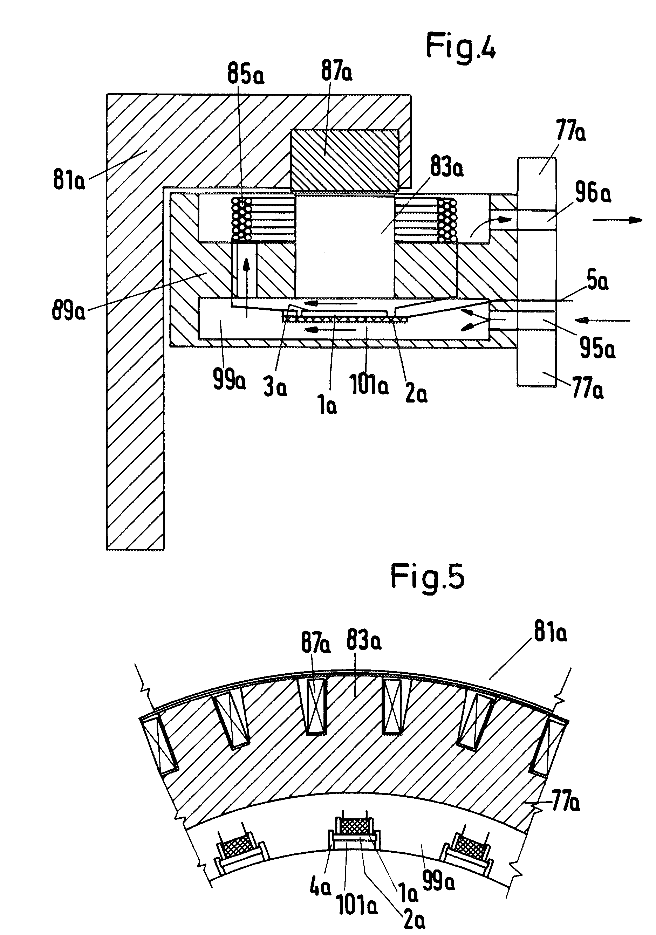

In den Figuren 4 und 5 ist in einem axialen Längs- bzw. Querschnitt eine gegenüber Figur 1 abgewandelte Ausführungsform der Erfindung dargestellt. Funktionsgleiche Teile sind mit den gleichen Bezugszeichennummern versehen wie in Figur 1, jedoch wurde zur Unterscheidung der Buchstabe a angehängt. Während in Figur 1 das elektrische Ventil 101 nur an seiner oberen Flachseite in direkten Kontakt mit dem Kühlfluid tritt, wird das elektrische Ventil 101a allseitig und deswegen besonders effektiv vom Kühlfluid direkt gekühlt. Wie Figur 5 zeigt, wird das elektrische Ventil 101a mit seinem Isolierträger 2a in Halteschienen 4a gehalten, die am Boden der Kammer 99a befestigt sind und beispielsweise aus einem Elastomer oder Kunststoff bestehen. Auf dem Isolierträger 2a ist nicht nur das Halbleiterelement 1a (z.B. IGBT) des elektrischen Ventils 101a sondern auch die zugehörige Steuer- und Schutzbeschaltung 3a angeordnet (Figur 4), die in den Figuren 1 bis 3 nicht gesondert dargestellt ist. Die Leitungsverbindungen zwischen dem Halbleiterelement 1a und der Steuer- und Schutzbeschaltung 3a kann somit extrem kurz gehalten werden, und es findet eine gemeinsame Kühlung aller auf dem Isolierträger 2a angeordneten Elemente statt. Zur Vermeidung von Beschädigungen etwa durch Beeinflussung durch das Kühlfluid und durch die sonstigen einwirkenden Kräfte (Erschütterungen, Lorenzkräfte) empfiehlt es sich, die elektrischen Anschlüsse mit einer Vergußmasse zu schützen. In Figur 4 sind exemplarisch auch die Stromzuleitungen von den elektrischen Ventilen 101a zu den Wicklungen 85a des Stators 81a dargestellt, die sehr kurz gehalten sind. Die äußeren elektrischen Anschlüsse (einschließlich Steueranschlüsse) sind mit 5a bezeichnet.

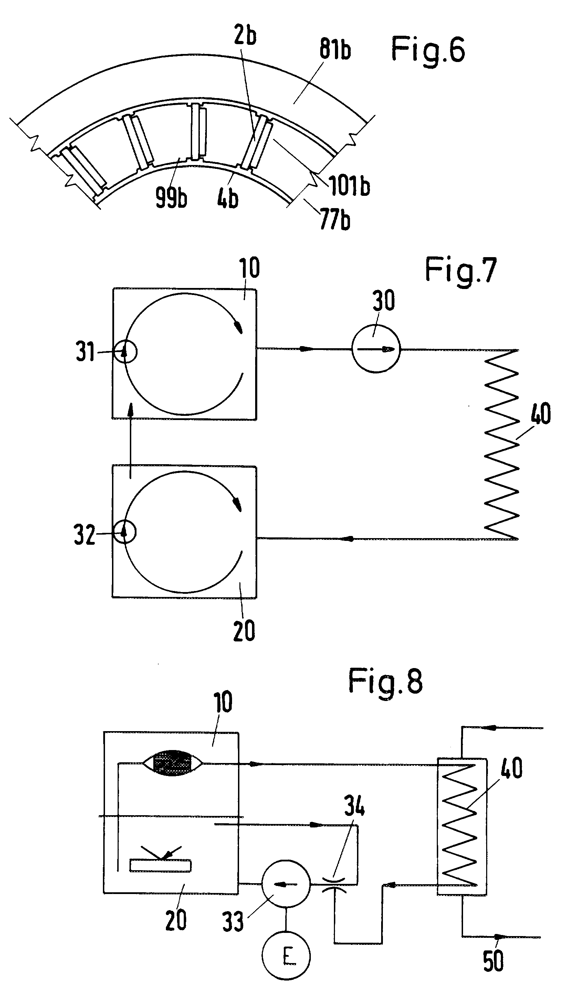

Figur 6 zeigt in einem axialen Querschnitt eine weitere abgewandelte Ausführungsform der Erfindung. Es wurden für funktionsgleiche Teile wiederum die Bezugszeichen der Figur 1 verwendet, wobei zur Unterscheidung lediglich der Buchstabe b angehängt wurde. Gegenüber Figur 5 wurden die elektrischen Ventile 101b um 90° Grad gedreht und liegen mit ihren Isolierträgern 2b in einer radialen Ebene parallel zur Motorlängsachse. Auch hierbei erfolgt eine allseitige Kühlung durch das Kühlfluid.

In Figur 7 ist schematisch eine vorteilhafte Ausführungsform für einen Kühlfluidkreislauf dargestellt. Das Kühlfluid wird durch eine Pumpe 30 in einem äußeren Kreislauf, in den ein Wärmetauscher 40 zur Abführung der Verlustwärme eingeschaltet ist, umgewälzt. Das wieder gekühlte Kühlfluid gelangt zunächst in die Kühlzone der Leistungselektronik 20, wo eine zusätzliche (innere) Umwälzpumpe 32 für eine vergleichsweise hohe Strömungsgeschwindigkeit sorgt, um den Wärmeaustausch zwischen den Verlustwärme erzeugenden Halbleiterelementen und dem Kühlfluid zu intensivieren. Entsprechendes findet auch in der Kühlzone für die Wicklungen des Elektromotors 10 statt, wo eine (innere) Umwälzpumpe 31 für eine erhöhte Strömungsgeschwindigkeit sorgt. Durch diese beiden inneren Kühlfluidumwälzungen wird ein besonders effektiver Wärmeaustausch ermöglicht, wobei die Umwälzpumpe 30 des äußeren Kühlkreislaufs eine wesentlich kleinere Leistung haben kann, als dies der Fall wäre, wenn die hohe Strömungsgeschwindigkeit allein durch die Pumpe 30 erzeugt würde, indem die gesamte Kühlfluidmenge mit der hohen Strömungsgeschwindigkeit umgewälzt würde. Ein abgewandeltes Schema des Kühlfluidkreislaufs ist in Figur 8 dargestellt. Obwohl auch hier für die Leistungselektronik 20 eine hohe Strömungsgeschwindigkeit sichergestellt und die Antriebsleistung für den Kühlfluidkreislauf insgesamt vergleichsweise niedrig gehalten wird, reicht eine einzige Umwälzpumpe 33 aus. Dies wird dadurch ermöglicht, daß das vom Wärmeaustauscher 40 kommende Kühlfluid der Umwälzpumpe 33 über ein Düsensystem 34 (z.B. Venturi-Düse) zugeführt wird. In dieses Düsensystem 34 mündet auch die Rückführleitung eines inneren Kühlkreislaufs der Leistungselektronik 20, der auch zur Kühlzone der Wicklungen des Elektromotors 10 offen ist. Auf diese Weise ist die pro Zeiteinheit im inneren Kühlkreislauf der Leistungselektronik 20 umgewälzte Kühlfluidmenge deutlich größer als die insgesamt im äußeren Kühlkreislauf umgewälzte Kühlfluidmenge. Die über das Kühlfluid (z.B, Öl) aufgenommene Wärme kann im Wärmetauscher 40 beispielsweise an den Kühlwasserkreislauf 50 eines nicht dargestellten Verbrennungsmotors abgegeben werden, der die elektrische Antriebsenergie für den Elektromotor 10 liefert.

Die Vorteile der vorliegenden Erfindung liegen neben der Verminderung des Platzbedarfs und der Verbesserung des Betriebsverhaltens der elektrischen Maschine insbesondere auch in dem Wegfall elektrischer Steckerverbindungen und Kühlleitungsanschlüssen für die Leistungselektronik. Dies wirkt sich nicht nur auf den Montageaufwand sondern auch auf die Betriebssicherheit der Maschine positiv aus. Der Aufwand für ein separates Gehäuse für die Leistungselektronik entfällt völlig.

## Patentansprüche

1. Elektrische Maschine zum Betrieb in einem Leistungsbereich von etwa 100 kW, deren Wicklungen (85) an steuerbare Halbleiterventile (101), insbesondere in Form von Leistungstransistoren angeschlossen sind und in unmittelbarem Wärmetauschkontakt mit einer Fluid-Kühlanordnung stehen, in deren zu einer Baueinheit mit den Wicklungen (85) vereinigten Kühlfluidkanal (93, 99) die Kühlanordnung eine Zwangsströmung eines Kühlfluids, insbesondere einer Kühlflüssigkeit, erzeugt,
dadurch gekennzeichnet,
daß die Halbleiterventile (101) ebenfalls Bestandteil der Baueinheit sind und mit dem Kühlfluid in dem Kühlfluidkanal (93, 99) gleichfalls in unmittelbarem Wärmetauschkontakt stehen,
daß die Wicklungen (85) eine Statorwicklung bilden und in Umfangsrichtung des Stators (77) verteilt angeordnet sind und daß die Halbleiterventile (101) an dem Stator (77) in räumlicher Nachbarschaft der mit ihnen verbundenen Wicklungen (85) angeordnet sind.

2. Maschine nach Anspruch 1,
dadurch gekennzeichnet,
daß dem Stator (77) ein Permanentmagnetrotor (81), insbesondere ein den Stator (77) umschließender Permanentmagnet-Außenrotor zugeordnet ist.

3. Maschine nach Anspruch 1 oder 2,
dadurch gekennzeichnet,
daß der Stator (77) ein die Wicklungen (85) tragendes Blechpaket (83) und eine zentrische Aussparung (97; 97m) aufweist und daß zumindest ein Teil der Halbleiterventile (101; 101m) mit einem in der Aussparung (97) verlaufenden Bereich (99; 99m) des Kühlfluidkanals (93, 99) in Wärmeaustauschkontakt stehen.

4. Maschine nach einem der Ansprüche 1 bis 3,
dadurch gekennzeichnet,
daß zumindest ein Teil der Halbleiterventile (101n) mit einem an eine axiale Stirnwand des Stators (77n) herangeführten Bereich des Kühlfluidkanals in Wärmeaustauschkontakt steht.

5. Maschine nach einem der Ansprüche 1 bis 4,
dadurch gekennzeichnet,
daß die Wicklungen (85) von einem den Kühlfluidkanal (93, 99) bildenden Gehäuse (89), insbesondere einem Kunststoffgehäuse, umschlossen sind und in direktem Wärmeaustauschkontakt mit dem Kühlfluid in dem Kühlfluidkanal (93, 99) stehen.

6. Maschine nach einem der Ansprüche 1 bis 5,
dadurch gekennzeichnet,
daß die Wicklungen (85) in Strömungsrichtung des Kühlfluids hinter den Halbleiterventilen (101) in Wärmeaustauschkontakt mit dem Kühlfluid stehen.

7. Maschine nach einem der Ansprüche 1 bis 6,
dadurch gekennzeichnet,
daß die Halbleiterventile (101) auf der Innenseite des Fluidkanals (93, 99) angeordnet sind.

8. Maschine nach einem der Ansprüche 1 bis 6,
dadurch gekennzeichnet,
daß die Halbleiterventile (101m) mit ihren aktiven Bereichen von der Innenseite des Fluidkanals (99m) abgewandt angeordnet sind.

9. Maschine nach einem der Ansprüche 7 oder 8,
dadurch gekennzeichnet,
daß die Halbleiterventile (101, 101m, 101n) einen integralen Teil der Wand des Fluidkanals (93, 99; 99m) bilden.

10. Maschine nach einem der Ansprüche 1 bis 7,
dadurch gekennzeichnet,
daß die Halbleiterventile (101a, 101b) allseitig in Wärmetauschkontakt mit dem Kühlfluid treten.

11. Maschine nach Anspruch 10,
dadurch gekennzeichnet,
daß die Halbleiterventile (101a, 101b) mit ihren Isolierträgern (2a, 2b) in Halteschienen (4a, 4b) gehalten werden, die im Gehäuse des Stators (77a, 77b) befestigt sind.

12. Maschine nach Anspruch 11,
dadurch gekennzeichnet,
daß die Halteschienen (4a, 4b) aus einem Elastomer oder Kunststoff gebildet sind.

13. Maschine nach einem der Ansprüche 1 bis 12,
dadurch gekennzeichnet,
daß die Steuer- und Schutzbeschaltung (3a) für das Halbleiterelement auf dem Isolierträger (2a) des Halbleiterventils (101a) angeordnet ist.

14. Maschine nach einem der Ansprüche 1 bis 13,
dadurch gekennzeichnet,
daß die elektrischen Anschlüsse des Halbleiterventils (101, 101a, 101b) durch eine Vergußmasse geschützt sind.

15. Maschine nach einem der Ansprüche 1 bis 14,
dadurch gekennzeichnet,
daß zumindest ein Teil der dem Kühlfluid ausgesetzten Wandoberfläche des Kühlfluidkanals (93, 99; 99m) oder der Oberflächen der Halbleiterventile (101, 101m) mit einer die Dicke der Kühlfluid-Strömungsgrenzschicht mindernden Oberflächen-Mikrostruktur versehen ist.

16. Maschine nach einem der Ansprüche 1 bis 15,
dadurch gekennzeichnet,
daß das Kühlfluid eine Flüssigkeit, vorzugsweise Wasser oder Öl, speziell Öl auf Mineralbasis oder Paraffinbasis oder ein synthetisches Öl, oder ein Zwei-Phasen-Fluid, vorzugsweise ein Kältemittel oder CO₂, ist.

17. Maschine nach einem der Ansprüche 1 bis 16,
dadurch gekennzeichnet,
daß Mittel (31, 32, 34) vorgesehen sind, die das im Kreislauf geführte Kühlfluid zumindest in der Kühlzone der Leistungselektronik (20) mit einer auf die Zeit bezogen deutlich höheren Kühlfluidmenge umwälzen als im Kreislauf selbst.

## Claims

1. An electric machine to operate in a range of capacity of approximately 100 kW, the windings (85) of which are connected to controllable semiconductor rectifiers (101), in particular in the form of power transistors and are in immediate thermal exchange contact with a fluid cooling arrangement, in the cooling fluid duct (93, 99) of which, combined into a structural unit with the windings (85), the cooling arrangement produces a forced flow of a cooling fluid, in particular of a cooling liquid,
characterised in that the semiconductor rectifiers (101) are likewise a component of the structural unit and likewise are in immediate thermal exchange contact with the cooling fluid in the cooling fluid duct (93, 99),
that the windings (85) form a stator winding and are arranged distributed in circumferential direction of the stator (77) and that the semiconductor rectifiers (101) are arranged on the stator (77) in spatial vicinity to the windings (85) which are connected with them.

2. A machine according to Claim 1,
characterised in that
a permanent magnet rotor (81), in particular a permanent magnet external rotor surrounding the stator (77) is associated with the stator (77).

3. A machine according to Claim 1 or 2,
characterised in that
the stator (77) has a stack of sheets (83) carrying the windings (85) and has a central recess (97; 97m) and that at least a part of the semiconductor rectifiers (101;101m) are in thermal exchange contact with a region (99, 99m) of the cooling fluid duct (93, 99) running in the recess (97).

4. A machine according to one of Claims 1 to 3,
characterised in that
at least a part of the semiconductor rectifiers (101n) is in thermal exchange contact with a region of the cooling fluid duct brought up against an axial end wall of the stator (77n).

5. A machine according to one of Claims 1 to 4,
characterised in that
the windings (85) are surrounded by a housing (89) forming the cooling fluid duct (93, 99), in particular a plastic housing, and are in direct thermal exchange contact with the cooling fluid in the cooling fluid duct (93, 99).

6. A machine according to one of Claims 1 to 5,
characterised in that
the windings (85) are in thermal exchange contact with the cooling fluid in the direction of flow of the cooling fluid behind the semiconductor rectifiers (101).

7. A machine according to one of Claims 1 to 6,
characterised in that
the semiconductor rectifiers (101) are arranged on the inner side of the fluid duct (93, 99).

8. A machine according to one of Claims 1 to 6,
characterised in that
the semiconductor rectifiers (101m) are arranged with their active regions facing away from the inner side of the fluid duct (99m).

9. A machine according to one of Claims 7 or 8,
characterised in that
the semiconductor rectifiers (101, 101m, 101n) form an integral part of the wall of the fluid duct (93, 99; 99m).

10. A machine according to one of Claims 1 to 7,
characterised in that
the semiconductor rectifiers (101a, 101b) enter into thermal exchange contact with the cooling fluid on all sides.

11. A machine according to Claim 10,
characterised in that
the semiconductor rectifiers (101a, 101b) are held with their insulating carriers (2a, 2b) in holding rails (4a, 4b) which are secured in the housing of the stator (77a, 77b).

12. A machine according to Claim 11,
characterised in that
the holding rails (4a, 4b) are formed from an elastomer or plastic.

13. A machine according to one of Claims 1 to 12,
characterised in that
the control- and protection wiring (3a) for the semiconductor element is arranged on the insulating carrier (2a) of the semiconductor rectifier (101a).

14. A machine according to one of Claims 1 to 13,
characterised in that
the electric connections of the semiconductor rectifier (101, 101a, 101b) are protected by a sealing compound.

15. A machine according to one of Claims 1 to 14,
characterised in that
at least a part of the wall surface of the cooling fluid duct (93, 99; 99m) which is exposed to the cooling fluid or of the surfaces of the semiconductor rectifiers (101, 101m) is provided with a surface microstructure reducing the thickness of the cooling fluid flow boundary layer.

16. A machine according to one of Claims 1 to 15
characterised in that
the cooling fluid is a liquid, preferably water or oil, specifically oil based on mineral or paraffin, or a synthetic oil, or a two-phase fluid, preferably a freezing medium or CO₂.

17. A machine according to one of Claims 1 to 16,
characterised in that
means (31, 32, 34) are provided which circulate the cooling fluid, which is carried in a circuit, at least in the cooling zone of the power electronics (20) with a distinctly higher quantity of cooling fluid in relation to time than in the circuit itself.

## Revendications

1. Machine électrique pour le fonctionnement dans un domaine de puissance d'à peu près 100 kW, dont les enroulements (85) sont raccordés à des soupapes à semi-conducteur (101) pouvant être commandées, en particulier en forme de transistors de puissance, et sont en contact d'échange de chaleur direct avec un dispositif de refroidissement à fluide, dans lequel dans un canal de fluide de refroidissement (93,99) réuni avec les enroulements (85) en une unité de montage, le dispositif de refroidissement engendre un écoulement forcé d'un fluide de refroidissement, en particulier un liquide de refroidissement,
caractérisée en ce que les soupapes à semi-conducteur (101) font également partie de l'unité de montage et sont également en contact d'échange de chaleur direct avec le fluide de refroidissement dans le canal de fluide de refroidissement (93,99), en ce que les enroulements (85) forment un bobinage de stator et sont agencés en étant répartis dans la direction périphérique du stator (77), et en ce que les soupapes à semi-conducteur (101) sont agencées sur le stator (77), à proximité des enroulements (85) reliés à elles.

2. Machine selon la revendication 1,
caractérisée en ce qu'au stator (77) est associé un rotor (81) à aimant permanent, en particulier un rotor externe à aimant permanent entourant le stator (77).

3. Machine selon l'une des revendications 1 ou 2,
caractérisée en ce que le stator (77) comporte un empilage de tôles (83) portant les enroulements (85) et un évidement central (97 ; 97m), et en ce qu'au moins une partie des soupapes à semi-conducteur (101 ; 101m) est en contact d'échange de chaleur avec une zone (99 ; 99m) du canal de fluide de refroidissement (93,99), s'étendant dans l'évidement (97).

4. Machine selon l'une des revendications 1 à 3,
caractérisée en ce qu'au moins une partie des soupapes à semi-conducteur (101n) est en contact d'échange de chaleur avec une zone du canal de fluide de refroidissement, approchée d'une paroi frontale axiale du stator (77n).

5. Machine selon l'une des revendications 1 à 4,
caractérisée en ce que les enroulements (85) sont entourés d'un boîtier (89), en particulier un boîtier en matière synthétique, formant le canal de fluide de refroidissement (93,99), et sont en contact d'échange de chaleur direct avec le fluide de refroidissement dans le canal de fluide de refroidissement (93,99).

6. Machine selon l'une des revendications 1 à 5,
caractérisée en ce que les enroulements (85) sont en contact d'échange de chaleur avec le fluide de refroidissement, en aval des soupapes à semi-conducteur (101), dans le sens d'écoulement du fluide de refroidissement.

7. Machine selon l'une des revendications 1 à 6,
caractérisée en ce que les soupapes à semi-conducteur (101) sont agencées sur la face interne du canal de fluide (93,99).

8. Machine selon l'une des revendications 1 à 6,
caractérisée en ce que les soupapes à semi-conducteur (101m) sont agencées en étant opposées avec leur zone active à la face interne du canal de fluide (99m).

9. Machine selon l'une des revendications 7 ou 8,
caractérisée en ce que les soupapes à semi-conducteur (101,101m,101n) forment une partie intégrale de la paroi du canal de fluide (93,99 ; 99m).

10. Machine selon l'une des revendications 1 à 7,
caractérisée en ce que les soupapes à semi-conducteur (101a,101b) sont en contact d'échange de chaleur, de tous côtés, avec le fluide de refroidissement.

11. Machine selon la revendication 10,
caractérisée en ce que les soupapes à semi-conducteur (101a,101b) sont maintenues par leurs supports isolants (2a,2b) dans des rails de maintien (4a,4b) qui sont fixés dans le boîtier du stator (77a,77b).

12. Machine selon la revendication 11,
caractérisée en ce que les rails de maintien (4a,4b) sont formés d'un élastomère ou de matière synthétique.

13. Machine selon l'une des revendications 1 à 12,
caractérisée en ce que le montage de commande et de protection (3a) pour l'élément à semi-conducteur est agencé sur le support isolant (2a) de la soupape à semi-conducteur (101a).

14. Machine selon l'une des revendications 1 à 13,
caractérisée en ce que les raccordements électriques de la soupape à semi-conducteur (101,101a,101b) sont protégés par une masse de scellement.

15. Machine selon l'une des revendications 1 à 14,
caractérisée en ce qu'au moins une partie de la surface de la paroi du canal de fluide de refroidissement (93,99 ; 99m) ou de la surface de la soupape à semi-conducteur (101,101m), soumise au fluide de refroidissement, est munie d'une microstructure superficielle réduisant l'épaisseur de la couche limite d'écoulement du fluide de refroidissement.

16. Machine selon l'une des revendications 1 à 15,
caractérisée en ce que le fluide de refroidissement est un liquide, de préférence de l'eau ou de l'huile, de l'huile spéciale à base de minéraux ou à base de paraffine, ou une huile synthétique, ou un fluide diphasique, de préférence un frigorigène ou du CO₂.

17. Machine selon l'une des revendications 1 à 16,
caractérisée en ce que l'on prévoit des moyens (31,32,34) qui font circuler le fluide de refroidissement dirigé en mouvement circulaire, au moins dans la zone de refroidissement de l'électronique de puissance (20), avec une quantité de fluide de refroidissement plus importante relativement au temps, que dans le mouvement circulaire.
